(19) Europäisches Patentamt
European Patent Office
Office européen des brevets

(11) **EP 4 768 969 A1**

(12) **EUROPEAN PATENT APPLICATION**
published in accordance with Art. 153(4) EPC

(43) Date of publication:
**01.07.2026 Bulletin 2026/27**

(21) Application number: **24904073.4**

(22) Date of filing: **26.11.2024**

(51) International Patent Classification (IPC):
**G01R 31/396** $^{(2019.01)}$    **G01R 31/392** $^{(2019.01)}$
**G01R 31/382** $^{(2019.01)}$    **G01R 31/36** $^{(2020.01)}$
**G06F 17/18** $^{(2006.01)}$

(52) Cooperative Patent Classification (CPC):
**G01R 31/36; G01R 31/382; G01R 31/392;**
**G01R 31/396; G06F 17/18;** Y02E 60/10

(86) International application number:
**PCT/KR2024/018874**

(87) International publication number:
**WO 2025/127508 (19.06.2025 Gazette 2025/25)**

(84) Designated Contracting States:
**AL AT BE BG CH CY CZ DE DK EE ES FI FR GB**
**GR HR HU IE IS IT LI LT LU LV MC ME MK MT NL**
**NO PL PT RO RS SE SI SK SM TR**
Designated Extension States:
**BA**
Designated Validation States:
**GE KH MA MD TN**

(30) Priority: **14.12.2023 KR 20230182220**

(71) Applicant: **LG Energy Solution, Ltd.**
**Seoul 07335 (KR)**

(72) Inventor: **CHOI, Yo Hwan**
**Daejeon 34122 (KR)**

(74) Representative: **Plasseraud IP**
**104 Rue de Richelieu**
**CS92104**
**75080 Paris Cedex 02 (FR)**

(54) **BATTERY MANAGEMENT DEVICE AND BATTERY MANAGEMENT METHOD**

(57)    A battery management device disclosed in the present document comprises: a communication unit for receiving battery data from multiple battery cells; and a control unit for fitting a discharge capacity graph obtained on the basis of the battery data to a sine function, determining a regression coefficient of maximizing a determination coefficient, on the basis of a data fitting function, and determining a maximum curvature point at which a curvature of the discharge capacity graph is maximized, on the basis of the regression coefficient

FIG.3

**Description**

**Technical Field**

CROSS-REFERENCE TO RELATED APPLICATION

This application claims priority to and the benefit of Korean Patent Application No. 10-2023-0182220 filed in the Korean Intellectual Property Office on December 14, 2023, the entire content of which is incorporated herein by reference.

TECHNICAL FIELD

Embodiments disclosed herein relate to a battery management apparatus and a battery management method for diagnosing a state of a battery.

**Background Art**

Recently, research and development of secondary batteries have been actively performed. Herein, the secondary batteries, which are chargeable/dischargeable batteries, may include all of conventional nickel (Ni)/cadmium (Cd) batteries, Ni/metal hydride (MH) batteries, etc., and recent lithium-ion batteries. Among the secondary batteries, a lithium-ion battery has a much higher energy density than those of the conventional Ni/Cd batteries, Ni/MH batteries, etc. Moreover, the lithium-ion battery may be manufactured to be small and lightweight, such that the lithium-ion battery has been used as a power source of mobile devices. In addition, the lithium-ion battery is attracting attention as a next-generation energy storage medium as a usage range thereof is expanded to a power source of electric vehicles.

A capacity of such a battery may sharply decrease at a specific point in time for various causes such as deviation in battery cell production/factories, internal degradation mechanisms, etc., and the sharp decrease in the capacity of the battery has to be early detected because of hindering stable and continuous battery use. However, for a general method of detecting a sharp decrease in battery capacity, a universal and objective method is not proposed, making consistent and efficient detection difficult.

**Disclosure**

**Technical Problem**

An embodiment disclosed herein provides a battery management apparatus and a battery management method in which a quantitative criterion for detecting a sharp decrease in a capacity of a battery is proposed to early detect a defect of the battery in a battery production stage.

Technical problems of the embodiments disclosed herein are not limited to the above-described technical problems, and other unmentioned technical problems would be clearly understood by one of ordinary skill in the art from the following description.

**Technical Solution**

A battery management apparatus according to an embodiment includes a communication unit configured to receive battery data from a plurality of battery cells and a control unit configured to fit a discharge capacity graph obtained based on the battery data to a data fitting function, determine a regression coefficient that maximizes a coefficient of determination based on the data fitting function, and determine, based on the regression coefficient, a maximum curvature point at which a curvature of the discharge capacity graph is maximum.

The control unit may be further configured to determine the plurality of battery cells as being defective based on that a curvature at the maximum curvature point is greater than a preset reference curvature.

The control unit may be further configured to transmit information about the plurality of battery cells determined as being defective to an external device through a communication unit.

The control unit may be further configured to fit the discharge capacity graph, obtained based on the battery data, to a data fitting function having a plurality of sine terms.

The control unit may be further configured to determine the maximum curvature point at which the curvature is maximum, based on a minimum search point and a maximum search point.

The control unit may be further configured to determine the maximum curvature point at which the curvature is maximum in a range from the minimum search point to the maximum search point.

The minimum search point may include a point at which a discharge capacity starts decreasing, and the maximum search point may include a maximum battery cycle that is a criterion for a battery test.

A battery management method according to an embodiment includes receiving battery data from a plurality of battery cells, fitting a discharge capacity graph obtained based on the battery data to a data fitting function, determining a regression coefficient that maximizes a coefficient of determination based on the data fitting function, and determining, based on the regression coefficient, a maximum curvature point at which a curvature of the discharge capacity graph is maximum.

The battery management method according to an embodiment may further include determining the plurality of battery cells as being defective based on that a curvature at the maximum curvature point is greater than a preset reference curvature.

The battery management method according to an embodiment may further include transmitting information about the plurality of battery cells determined as being defective to an external device through a communication unit.

The fitting of the discharge capacity graph to the data fitting function may include fitting the discharge capacity graph, obtained based on the battery data, to a data fitting function having a plurality of sine terms.

The determining of the maximum curvature point may include determining the maximum curvature point at which the curvature is maximum, based on a minimum search point and a maximum search point.

The determining of the maximum curvature point may include determining the maximum curvature point at which the curvature is maximum in a range from the minimum search point to the maximum search point.

The minimum search point may include a point at which a discharge capacity starts decreasing, and the maximum search point may include a maximum battery cycle that is a criterion for a battery test.

## Advantageous Effects

With a battery management apparatus according to an embodiment, a quantitative criterion and a detection scheme for a point in time of a sharp decrease in a capacity of a battery may be provided and a battery cell may be sorted which satisfies a discharge capacity reference value at a specific cycle point in time and further has a possibility of the sharp decrease in the capacity of the battery in a battery sampling quality inspection process.

## Description of Drawings

FIG. 1 is a block diagram showing a configuration of a general battery system including a battery management apparatus according to an embodiment.

FIG. 2 is a block diagram showing a configuration of a battery management apparatus according to an embodiment.

FIG. 3 schematically shows a flow for a battery management apparatus according to an embodiment to determine based on a curvature whether a battery is defective.

FIG. 4 shows an osculating circle used in a battery management apparatus according to an embodiment.

FIG. 5 shows a radius of curvature used in a battery management apparatus according to an embodiment.

FIG. 6 shows that a maximum curvature point is detected at an end point of a search range in a battery management apparatus according to an embodiment.

FIG. 7 shows that a maximum curvature point is detected at a start point of a search range in a battery management apparatus according to an embodiment.

FIG. 8 shows that a maximum curvature point is detected at an intermediate point of a search range in a battery management apparatus according to an embodiment.

FIG. 9 shows that a maximum curvature point is detected after an intermediate point of a search range in a battery management apparatus according to an embodiment.

FIG. 10 is a control flowchart of a battery management method according to an embodiment.

## Mode for Invention

Hereinafter, various embodiments disclosed herein will be described in detail with reference to the accompanying drawings. In this document, identical reference numerals will be used for identical components in the drawings, and the identical components will not be redundantly described.

For various embodiments disclosed herein, specific structural or functional descriptions are only exemplified for the purpose of describing the embodiments, and various embodiments disclosed herein may be implemented in various forms, and should not be construed as being limited to the embodiments described herein.

As used in various embodiments, the terms "1", "2nd", "first", "second", or the like may modify various components regardless of importance, and do not limit the components. For example, a first component may be named as a second component without departing from the right scope of an embodiment disclosed herein, and similarly, the second component may be named as the first component.

Terms used herein are used for only describing a specific exemplary embodiment and may not have an intention to limit the scope of other exemplary embodiments. It is to be understood that the singular forms include plural references unless the context clearly dictates otherwise.

All terms including technical or scientific terms used herein have the same meaning as commonly understood by those of ordinary skill in the art to which the embodiments disclosed herein belong. It will be further understood that terms, such as those defined in commonly used dictionaries, should be interpreted as having a meaning that is identical to or similar with their meaning in the context of the relevant art and will not be interpreted in an idealized or overly formal sense unless expressly so defined herein. In some cases, the terms defined herein may be interpreted to exclude embodiments disclosed herein.

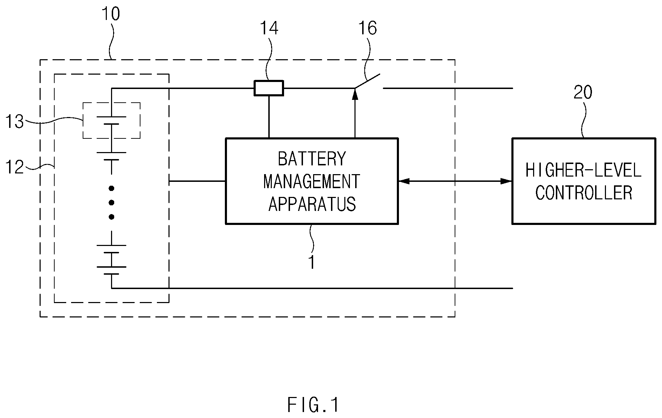

FIG. 1 is a block diagram showing a configuration of a general battery system including a battery management apparatus according to various embodiments.

Specifically, FIG. 1 schematically shows a battery system 10 and a higher-level controller 20 included in a higher-level system according to an embodiment disclosed herein.

As shown in FIG. 1, the battery system 10 may include a plurality of battery modules 12, a sensor unit 14, a switching unit 16, and a battery management apparatus 1. The battery system 10 may include the battery module 12, the sensor unit 14, the switching unit 16, and the battery management apparatus 1 provided in plural.

The plurality of battery modules 12 may include at least one chargeable/dischargeable battery cells 13. The battery cell 13 may include a positive electrode, a positive electrode material, a negative electrode, a negative electrode material, a separator, polymer, and a case. In this case, the plurality of battery modules 12 may be connected in series or in parallel.

The sensor unit 14 may include a current sensor 2, a voltage sensor 3, and a temperature sensor (not shown).

The current sensor 2 may detect a current used in a process of determining a discharge capacity graph of the battery cell 13.

The current sensor 2 may include any component for generating a signal corresponding to a magnitude of a charging current, and may be installed on a charging/discharging path in which the charging/discharging current flows in a battery.

The current sensor 2 may measure a battery current flowing in the battery, i.e., a charging current and a discharging current, and transmit a measurement result to the battery management apparatus 1. According to an embodiment, the current sensor 2 may measure the battery current at predetermined intervals and transmit a measurement result to the battery management apparatus 1, in a charging cycle for charging the battery with power of an external device or a discharging cycle for discharging the battery.

The voltage sensor 3 may be connected in parallel with the battery and configured to detect a battery voltage across opposite ends of the battery and generate a voltage signal indicating the detected battery voltage.

The temperature sensor (not shown) may be configured to measure a battery temperature and generate a temperature signal indicating the measured battery temperature. The temperature sensor may be arranged in a case to measure a temperature close to an actual temperature of the battery. For example, the temperature sensor may be attached to a surface of at least one battery cell included in a cell group and detect the surface temperature of the battery cell as the battery temperature.

The temperature sensor may be configured to measure an external temperature that is a temperature at a predetermined position spaced apart from the battery and generate the temperature signal indicating the measured external temperature. The temperature sensor may be arranged at a predetermined position outside the case in which heat exchange is made between the battery and the atmosphere. According to an embodiment, the temperature sensor may be implemented in combination of one or two or more of known temperature detection elements such as a thermocouple, a thermistor, a bimetal, etc.

While the sensor unit 14 is connected between a positive electrode of the battery cell 13 and the switching unit 16 in FIG. 1, a connection relationship between components shown in FIG. 1 may be an example and is not limited thereto.

The switching unit 16 may be serially connected to a positive (+) terminal side or a negative (-) terminal side of the battery module 12 to control a charging/discharging current flow of the battery module 12. For example, for the switching unit 16, at least one relay, a magnetic contactor, etc., may be used, depending on the specification of the battery system 10.

The battery management apparatus 1 may perform control and management to prevent over-charging and over-discharging by monitoring voltage, current, temperature, etc., of the battery system 10, and may include, for example, a battery management system (BMS).

The battery management apparatus 1, which is an interface for receiving measurement values of the above-described various parameter values, may include a plurality of terminals and a circuit, etc., connected thereto to process input values. Further, the battery management apparatus 1 may control the switching unit 16, for example, on/off of a relay, a contactor, etc., and may be connected to the battery module 12 to monitor a state of each battery module 12.

The battery management apparatus 1 may receive temperature data, voltage data, and current data from the sensor unit 14 to obtain battery state information and diagnose a state of the battery.

The higher-level controller 20 may transmit a control signal for controlling the battery module 12 to the battery management apparatus 1. Thus, the battery management apparatus 1 may be controlled in terms of an operation thereof based on the control signal applied from the higher-level controller 20. Also, the battery module 12 may be a component included in an energy storage system (ESS). In this case, the higher-level controller 20 may be a control unit (BBMS) of a battery bank including the plurality of battery systems 10 or an ESS control unit for controlling the entire ESS including a plurality of banks. However, the battery system 10 is not limited to such a purpose.

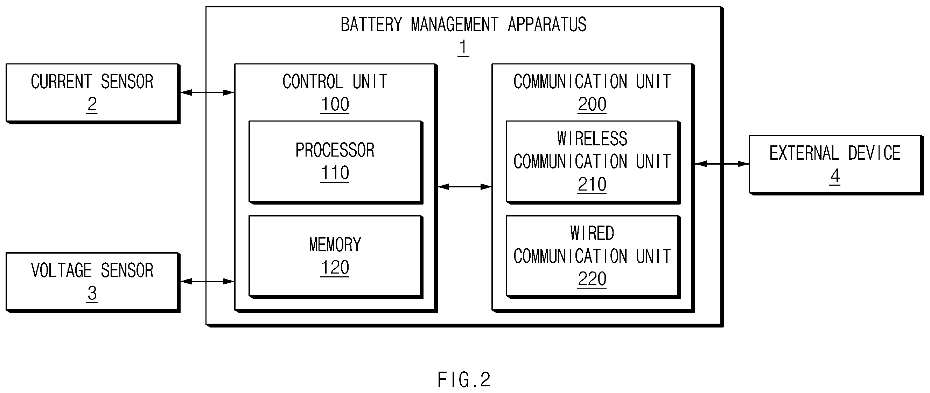

FIG. 2 is a block diagram showing a configuration of a battery management apparatus according to an embodiment.

Referring to FIG. 2, the battery management apparatus 1 according to an embodiment may include a control unit 100 including at least one processor 110 and a memory 120 and a communication unit 200, and may diagnose a battery by communicating with an external device 4 through the communication unit 200.

According to an embodiment, the external device 4 communicating with the battery management apparatus 1 may include a user terminal of a server device that transmits a diagnosis result of the battery management apparatus 1.

Specifically, when the external device 4 is a user terminal, the control unit 100 of the battery management apparatus 1 may transmit a diagnosis result of the battery to the user terminal to enable a user to check the diagnosis result. In this case, the user terminal may include, but not limited to, a personal computer (PC), a terminal, a portable telephone, a smart phone, a handheld device, a wearable device, etc.

When the external device 4 is a server device, the server device may be implemented with various computing devices such as workstations, clouds, data drives, data stations, etc. The server device may be implemented as one or more server devices physically or logically separated based on a function, a detailed configuration thereof, data, etc., and data may be transmitted and received through communication between server devices and the transmitted and received data may be processed.

The battery management apparatus 1 according to an embodiment may mean any electronic device including the processor 110 and the memory 120, and may be mounted on a vehicle to operate. Hereinbelow, each component of the battery management apparatus 1 may be described in detail.

The communication unit 200 may include a wireless communication unit 210 and a wired communication unit 220 to communicate with the external device 4. The communication unit 200 may transmit and receive a program for feature calculation, class classification, and lifetime estimation for a battery cell or various data, etc., to and from a separately provided external server.

The wireless communication unit 210 may include at least one of a short-range communication module or a long-range communication module.

The short-range communication module may communicate with the external device 4 adjacent to the battery management apparatus 1 by using a short-range communication method. Herein, the short-range communication module may use one communication method among Bluetooth, Bluetooth low energy (BLE), infrared data association (IrDA), Zigbee, WiFi, WiFi Direct, ultra-wideband (UWB), or near field communication (NFC).

The long-range wireless communication module may include a communication module performing various types of long-range communication, and may include a mobile communication module. The mobile communication unit may transmit and receive a radio signal to and from at least one of a base station, an external terminal, or the external device 4 over a mobile communication network. The long-range communication module may communicate with the external device 4 or other electronic devices, etc., through a nearby access point (AP). The AP may connect a local area network (LAN) to which the battery management apparatus 1 is connected to a wide area network (WAN) to which the communication server is connected. Thus, the battery management apparatus 1 may be connected to the communication server through the external device 4 and the WAN to communicate with each other.

The wired communication unit 220 may access the wired communication network and communicate with the external device 4 through the wired communication network. For example, the wired communication unit 220 may access the wired communication network through Ethernet (IEEE 802.3, technical standards), access the wired communication network through CAN communication, and transmit and receive data to and from the external devices 4 through the wired communication network.

The battery management apparatus 1 according to an embodiment may include an input/output interface (not shown). An interface may be provided to allow data to be transmitted and received by connecting an input device (not shown) such as a keyboard, a mouse, a touch panel, etc., an output device such as a display (not shown), etc., and the processor 110.

The memory 120 may store various information required for driving of the battery management apparatus 1. Specifically, the memory 120 may store an operating system and a program required for driving of the battery management apparatus 1 or store data required for driving of the battery management apparatus 1.

Specifically, the memory 120 may store various programs regarding feature calculation, class classification, and lifetime estimation of the battery cell. Moreover, the memory 120 may store various data such as a voltage, a current, feature data, etc., of each battery cell.

The memory 120 may also store a regression coefficient and a reference curvature of the battery cell 13, estimated by the processor 110.

The memory 120 may include a volatile memory 120 such as a static random access memory (S-RAM) and a dynamic random access memory (D-RAM) to temporarily memorize data. The memory 120 may also include a non-volatile memory 120 such as a read only memory (ROM), an erasable programmable read only memory (EPROM), and an electrically erasable programmable read only memory (EEPROM), to store data for a long time.

The processor 110 may control in overall the battery management apparatus 1 by outputting a control signal. The processor 110 may include one CPU or graphics processing unit (GPU) or a plurality of CPUs or GPUs. In this case, the processor 110 may be implemented as an array of multiple logic gates, or may be implemented as a combination of the general-purpose microprocessor 110 and the memory 120 storing a program executable on the microprocessor 110.

The memory 120 and the processor 110 may be included in the control unit 100 that controls the above-described components to determine whether a defect occurs in a battery cell.

Specifically, the control unit 100 may fit a discharge capacity graph obtained based on the battery data to a data fitting function and determine a regression coefficient that maximizes a coefficient of determination based on the data fitting function. That is, the control unit 100 may fit the discharge capacity graph to a sine function to remove noise of data and obtain a constant curvature profile.

The control unit 100 may determine a maximum curvature point that maximizes a curvature of the discharge capacity graph based on the regression coefficient, and compare the maximum curvature point with a preset reference curvature to determine whether a battery cell is defective.

Specifically, the control unit 100 may determine, as a defective battery cell, a battery cell having a curvature at a maximum curvature point being greater than a preset reference curvature, and transmit information about a plurality of battery cells determined as being defective to the external device 4 through the communication unit 200 to notify a battery user or inspector of whether the battery cell is defective.

The control unit 100 may fit the discharge capacity graph obtained based on the battery data to a sine function having a plurality of sine terms, and determine a maximum curvature point having a maximum curvature based on a search point and a maximum search point. Specifically, the control unit 100 may limit a range of a cycle for determining the maximum curvature point to a specific minimum/maximum cycle range.

That is, the control unit 100 may determine the maximum curvature point having a maximum curvature in a range from a minimum search point to a maximum search point.

As such, the battery management apparatus 1 according to an embodiment may detect a defective battery cell based on a curvature at an early point in time at which a defect may not be determined by other defect detection algorithms.

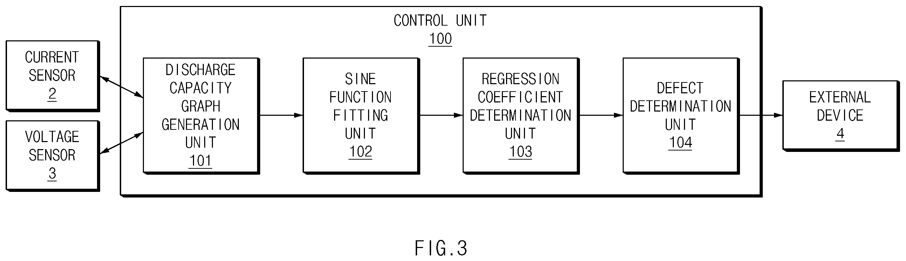

FIG. 3 schematically shows a flow for a battery management apparatus according to an embodiment to determine based on a curvature whether a battery is defective. Components 101 to 104 in FIG. 3 may be implemented in the form of a software block, and may be stored in the memory 120 and executed by the processor 110.

Referring to FIG. 3, the control unit 100 may receive a current value and a voltage value from the current sensor 2 and the voltage sensor 3.

A discharge capacity graph generation unit 101 of the control unit 100 may generate a discharge capacity graph based on a current value and a voltage value, and the discharge capacity graph may mean a graph showing a total energy amount provided by the battery in use of charged power with respect to time or cycle. The control unit 100 may generate a state of health (SOH) graph in place of the discharge capacity graph, but an embodiment will be described using the discharge capacity graph as an example.

A sine function fitting unit 102 of the control unit 100 may fit the discharge capacity graph generated based on the battery data to a sine function having a plurality of terms. The number of sine function terms is not limited, but $a1 * \sin(b1 * x + c1) + a2 * \sin(b2 * x + c2)$ having two sine terms may be applied as a fitting function most appropriate for the discharge capacity graph to prevent over-fitting and both end distortion.

Thereafter, a regression coefficient determination unit 103 of the control unit 100 may determine a regression coefficient that maximizes a coefficient of determination R-squared based on a sine function, that is, the control unit 100 may determine a regression coefficient that maximizes a coefficient of determination to search for a regression model capable of optimally describing a relationship between a dependent variable and an independent variable. The regression coefficient may be experimentally determined, and in the discharge capacity graph, a sine sum function having a plurality of terms has a higher coefficient of determination than a single sine function or an exponential function, such that a sine sum function having a plurality of terms may be used as a fitting function.

A defect determination unit 104 of the control unit 100 may determine the plurality of battery cells as being defective based on that a curvature at the maximum curvature point determined in the discharge capacity graph fitted by the sine function is greater than a preset reference curvature.

Thereafter, the control unit 100 may transmit information about a battery cell determined as being defective to the external device 4 through the communication unit 200, such that the battery user or manager may early know a defect of the battery.

Conventionally, there are a method of using raw data to detect a sharp decrease in the capacity of the battery, a method of using a moving average, a method of using an intersection of tangent lines, etc., but existing methods may not consistently find the maximum curvature point. On the other hand, the battery management apparatus 1 according to an embodiment may determine the maximum curvature point based on the discharge capacity graph fitted to the sine function, thereby providing a battery capacity sharp decrease detection algorithm that is consistent and not sensitive to noise.

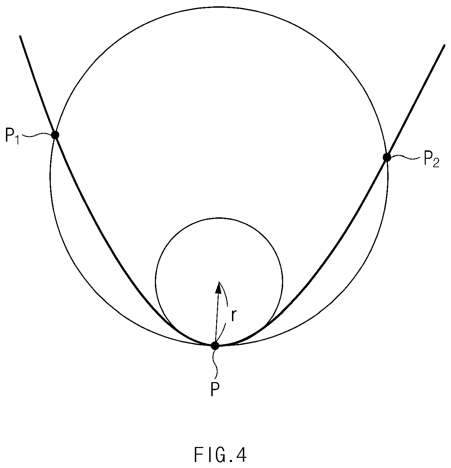

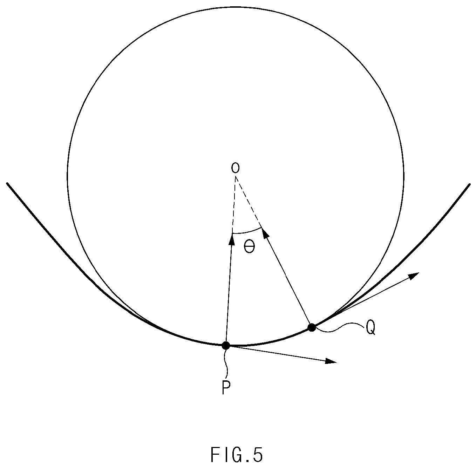

FIG. 4 shows an osculating circle used in a battery management apparatus according to an embodiment, and FIG. 5 shows a radius of curvature used in a battery management apparatus according to an embodiment.

Referring to FIG. 4, a curvature may mean a degree to which a curve is bent, and may be calculated as a reciprocal of a radius of curvature, r, of an osculating circle.

Specifically, as shown in FIG. 4, for a circle that passes three points P, P1, and P2 on a curve y = f(x), a limit of a circle that occurs when P1 and P2 infinitely approach to P is an osculating circle, and a radius of the osculating circle may mean the radius of curvature, r.

Next, referring to FIG. 5, as an angle between a normal vector perpendicular to each tangent vector at two points P and Q is $\theta$, given that an arc PQ is equal to a curve PQ, then a central angle of a fan is also $\theta$. When a length of the arc PQ is s, s = r$\theta$ such that the radius of curvature, r, may be determined by an equation provided below.

【Equation 1】

$$r = \left| \lim_{P \to Q} \frac{\Delta PQ}{\Delta \theta} \right| = \left| \lim_{\theta \to 0} \frac{s}{\theta} \right| = \left| \frac{ds}{d\theta} \right|$$

The control unit 100 may obtain Equation 2 by modifying Equation 1 and differentiate a curvature length in Equation 2 to obtain Equation 3 and Equation 4.

【Equation 2】

$$r = \left| \frac{ds}{d\theta} \right| = \left| \frac{ds}{dt} \frac{dt}{d\theta} \right|$$

【Equation 3】

$$\frac{ds}{dt} = \sqrt{\left( \frac{ds}{dt} \right)^2 + \left( \frac{dy}{dt} \right)^2} = \sqrt{x'^2 + y'^2}$$

【Equation 4】

$$\frac{dt}{d\theta} = \frac{x'^2 + y'^2}{y''x' - x''y'}$$

The control unit 100 may generate Equation 5 by organizing Equation 3 and Equation 4 with respect to $\dfrac{ds}{d\theta}$.

【Equation 5】

$$\frac{ds}{d\theta} = \sqrt{x'^2 + y'^2}\, \frac{x'^2 + y'^2}{y''x' - x''y'}$$

The control unit 100 may calculate a curvature as in Equation 6 based on a relationship in which a curvature k is a reciprocal of the radius of curvature, r.

【Equation 6】

$$k = \frac{|y''x' - x''y|}{(x'^2 + y'^2)^{1.5}}$$

As such, the control unit 100 may calculate a curvature of a graph to determine, as a sharp decrease point of the capacity of the battery, a point in which the curvature of the discharge capacity graph is maximum.

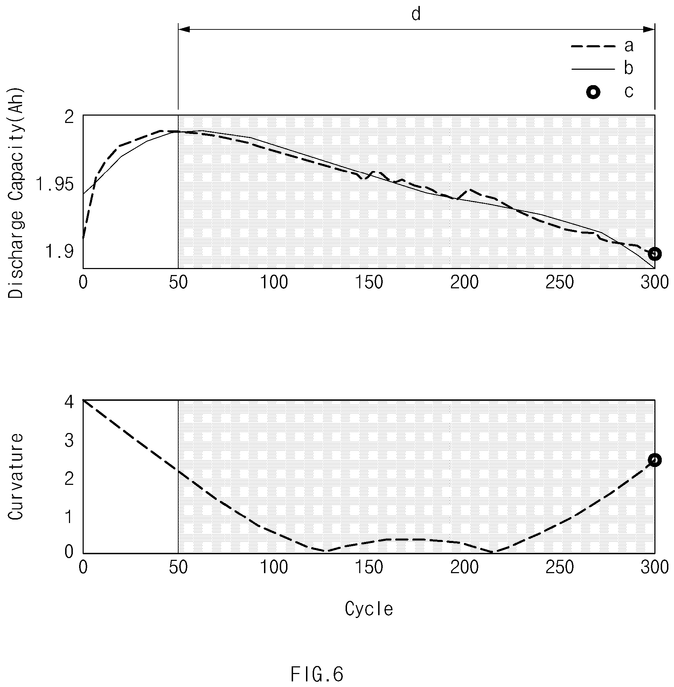

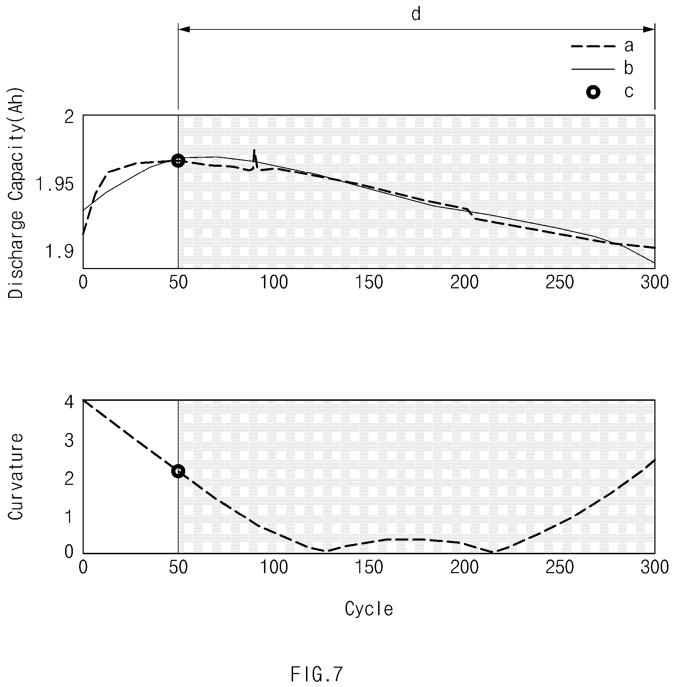

FIG. 6 shows that a maximum curvature point is detected at an end point of a search range in a battery management apparatus according to an embodiment, and FIG. 7 shows that the maximum curvature point is detected at a start point of the search range in the battery management apparatus according to an embodiment.

Referring to FIG. 6, the control unit 100 may obtain a discharge capacity graph b by fitting raw data a to a sine function. The control unit 100 may detect a maximum curvature of the discharge capacity graph b, and specifically, the control unit 100 may determine a maximum curvature point at which a curvature is maximum in a search range d from a minimum search point to a maximum search point.

That is, the control unit 100 may determine the minimum search point as a cycle 50 point and the maximum search point as a cycle 300 point, as shown in FIG. 6.

Specifically, due to an activation process by charging/discharging repeated in a battery cell quality test process, the capacity of the battery may temporarily increase in early cycles, such that the minimum search point may include a point at which the discharge capacity starts decreasing. Specifically, up to initial several tens of cycles in a battery test process, the capacity may increase due to a reaction of an internal chemical substance in an activation process of the battery charging/discharging process. Thus, the minimum search point may include a point at which the capacity increasing starts decreasing in the initial section.

As the discharge capacity in a specific cycle being measured as above n % with respect to the initial discharge capacity is determined as a battery cell quality test pass in the battery cell quality test process, the maximum search point may include a maximum battery cycle that is a criterion for the battery test.

In FIG. 6, a maximum curvature point c detected by the control unit 100 may be located at an end point of a search range d, and as the maximum curvature point c is not detected in the search range d, the control unit 100 may determine the battery as being normal.

Moreover, referring to the lower graph of FIG. 6, a substantial maximum value of a curvature may be determined to be a cycle 0 point and a maximum value of a curvature determined by the control unit 100 may be determined to be a cycle 300 point as a curvature maximum value in the search range d.

Next, referring to FIG. 7, the control unit 100 may obtain the discharge capacity graph b by fitting the raw data a to the sine function as in FIG. 6. The control unit 100 may determine the maximum curvature point having a maximum curvature in the search range d from the minimum search point to the maximum search point.

That is, the control unit 100 may determine the minimum search point as a cycle 50 point and the maximum search point as a cycle 300 point. However, the minimum search point and the maximum search point may be set differently according to a type and a purpose of a battery cell.

In FIG. 7, the maximum curvature point c detected by the control unit 100 may be located at a start point of the search range d, and as the maximum curvature point c is not detected in the search range d, the control unit 100 may determine the battery as being normal.

Moreover, referring to the lower graph of FIG. 7, a substantial maximum value of a curvature may be determined to be a cycle 0 point and a maximum value of a curvature determined by the control unit 100 may be determined to be a cycle 50 point as a curvature maximum value in the search range d.

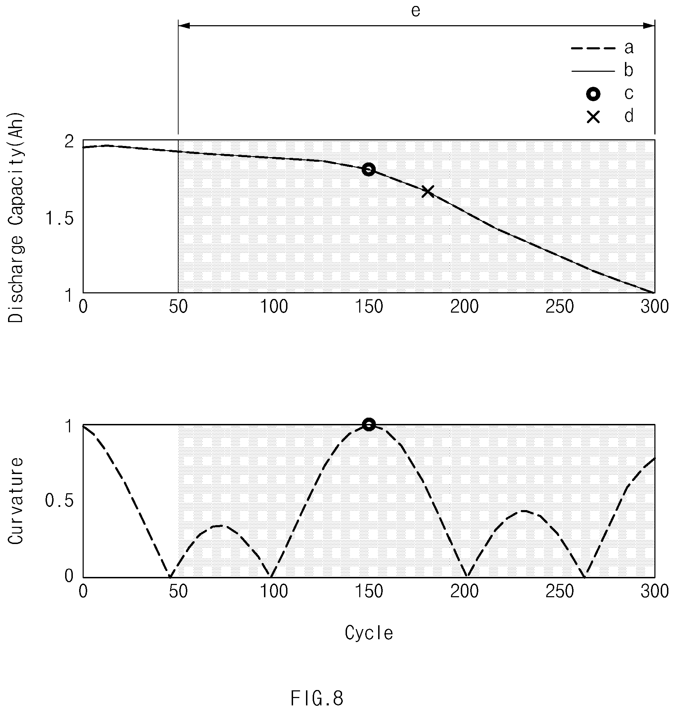

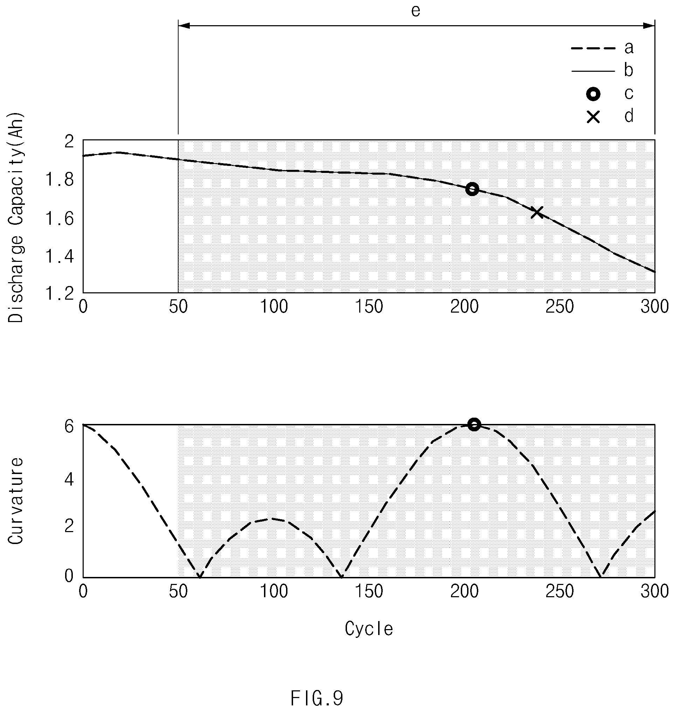

FIG. 8 shows that a maximum curvature point is detected at an intermediate point of a search range in a battery management apparatus according to an embodiment, and FIG. 9 shows that the maximum curvature point is detected after the intermediate point of the search range in the battery management apparatus according to an embodiment.

Referring to FIG. 8, the control unit 100 may obtain the discharge capacity graph b by fitting the raw data a to a sine function. The control unit 100 may determine the maximum curvature point having a maximum curvature in a search range e from the minimum search point to the maximum search point.

That is, the control unit 100 may determine the minimum search point as a cycle 50 point and the maximum search point as a cycle 300 point.

In FIG. 8, the maximum curvature point c detected by the control unit 100 may be located at a cycle 150 point that is the intermediate point of the search range e, and as the maximum curvature point c is detected in the search range e, the control unit 100 may determine the battery as being defective.

Referring to the lower graph of FIG. 8, a substantial maximum value of the curvature may include two points, the cycle 0 point and the cycle 150 point, but the maximum value of the curvature determined by the control unit 100 may be determined to be the cycle 150 point as the curvature maximum value in the search range e.

A test dissatisfaction point d at which a discharge capacity is less than n % with respect to an initial discharge capacity in the battery cell quality test process is about a cycle 180 point, such that the control unit 100 may detect the cycle 150 point, which is the maximum curvature point, earlier than the test dissatisfaction point d.

Likewise, referring to FIG. 9, the control unit 100 may obtain the discharge capacity graph b by fitting the raw data a to a sine function. The control unit 100 may determine the maximum curvature point at which the curvature is maximum in the search range e from the minimum search point to the maximum search point, and the control unit 100 may determine the minimum search point to be the cycle 50 point and the maximum search point to be the cycle 300 point.

In FIG. 9, the maximum curvature point c detected by the control unit 100 may be located at a cycle 200 point that is to the right of the intermediate point of the search range e, and as the maximum curvature point c is detected in the search range e, the control unit 100 may determine the battery as being defective.

Referring to the lower graph of FIG. 9, a substantial maximum value of the curvature may include two points, the cycle 0 point and the cycle 200 point, but the maximum value of the curvature determined by the control unit 100 may be determined to be the cycle 200 point as the curvature maximum value in the search range e.

The test dissatisfaction point d at which a discharge capacity is less than n % with respect to the initial discharge capacity in the battery cell quality test process is about a cycle 240 point, such that the control unit 100 may detect the cycle 200 point, which is the maximum curvature point, earlier than the test dissatisfaction point d.

Thus, the control unit 100 may remove noise and actively and quickly detect whether the capacity of the battery sharply decreases.

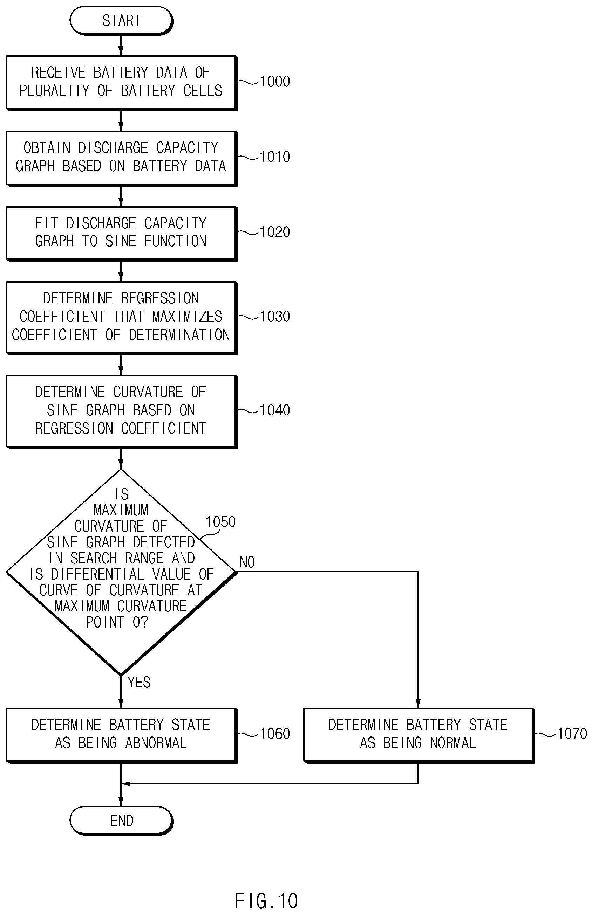

FIG. 10 is a control flowchart of a battery management method according to an embodiment.

Referring to FIG. 10, the control unit 100 may receive battery data of a plurality of battery cells from the communication unit 200, in operation 1000. The battery data may be received from a sensor unit through wired/wireless communication or from an external server such as a cloud server through the communication unit 200.

Thereafter, the control unit 100 may obtain a discharge capacity graph based on the received battery data, in operation 1010. The control unit 100 may generate an SOH graph in place of the discharge capacity graph, and an algorithm for deriving a maximum curvature of the graph may be equally applied.

The control unit 100 may fit the obtained discharge capacity graph to a sine function in operation 1020, and determine a regression coefficient that maximizes a coefficient of determination for optimization in operation 1030. Thereafter, the control unit 100 may determine a curvature of the discharge capacity graph fitted to the sine graph based on a regression coefficient determined in a preset search range, in operation 1040.

The control unit 100 may determine whether the maximum curvature of the sine graph exceeds a preset reference curvature in operation 1050, determine a battery state as being abnormal when the maximum curvature exceeds the preset reference curvature (yes in operation 1050) in operation 1060, and determine the battery state as being normal when the maximum curvature does not exceed the preset reference curvature (no in operation 1050) in operation 1070.

As such, the battery management apparatus 1 according to an embodiment may early detect a sharp decrease in a capacity of a battery, thereby efficiently detecting a defect of the battery and securing a material for analyzing a cause for the defect of the battery.

Meanwhile, disclosed embodiments may be implemented in the form of a recording medium that stores an instruction executable by a computer. The instruction may be stored in the form of a program code, and, when executed by a processor, may generate a program module and perform operations according to disclosed embodiments. The recording medium may be implemented as a computer-readable recording medium.

The computer-readable recording medium may include any type of recording media that store an instruction interpretable by a computer. For example, the computer-readable recording medium may include ROM, RAM, a magnetic tape, a magnetic disk, flash memory, an optical data storage device, etc.

In addition, the computer-readable recording medium may be provided in the form of a non-transitory storage medium. Herein, the term 'non-transitory storage medium' simply means that the storage medium is a tangible device, and does not include a signal (e.g., an electromagnetic wave), but this term does not differentiate between where data is semi-permanently stored in the storage medium and where the data is temporarily stored in the storage medium. For example, the 'non-transitory storage medium' may include a buffer storing data temporarily.

According to an embodiment, a method according to various embodiments disclosed herein may be included and provided in a computer program product. The computer program product may be traded as a product between a seller and a buyer. The computer program product may be distributed in the form of a machine-readable recording medium (e.g., compact disc read only memory (CD-ROM)), or be distributed (e.g., downloaded or uploaded) online via an application store (e.g., PlayStore™), or between two user devices (e.g., smart phones) directly. When distributed online, at least a part of the computer program product (e.g., a downloadable app) may be temporarily generated or at least temporarily stored in the machine-readable recording medium, such as memory of the manufacturer's server, a server of the application store, or a relay server.

Even though all components constituting an embodiment disclosed herein have been described above as being combined into one or operating in combination, the embodiments disclosed herein are not necessarily limited to the embodiment. That is, within the object scope of the embodiments disclosed herein, all the components may operate by being selectively combined into one or more.

Moreover, terms such as "include", "constitute" or "have" described above may mean that the corresponding component may be inherent unless otherwise stated, and thus should be construed as further including other components rather than excluding other components. All terms including technical or scientific terms have the same meanings as those generally understood by those of ordinary skill in the art to which the embodiments disclosed herein pertain, unless defined otherwise. The terms used generally like terms defined in dictionaries should be interpreted as having meanings that are the same as the contextual meanings of the relevant technology and should not be interpreted as having ideal or excessively formal meanings unless they are clearly defined in this document.

The above description is merely illustrative of the technical idea disclosed herein, and various modifications and variations will be possible without departing from the essential characteristics of the embodiments disclosed herein by those of ordinary skill in the art to which the embodiments disclosed herein pertains. Therefore, the embodiments disclosed herein are intended for description rather than limitation of the technical spirit of the embodiments disclosed herein and the scope of the technical spirit disclosed herein is not limited by these embodiments. The protection scope of the technical spirit disclosed herein should be interpreted by the following claims, and all technical spirits within the same range should be understood to be included in the range of this document.

**List of Reference Numerals for Major Elements**

1: Battery Management Apparatus
2: Voltage Sensor
3: Current Sensor
4: External Device
10: Battery System
12: Plurality of Battery Modules
13: Battery Cell
14: Sensor Unit
16: Switching Unit
20: Higher-Level Controller
100: Control Unit
110: Processor
120: Memory
200: Communication Unit
210: Wireless Communication Unit
220: Wired Communication Unit

**Claims**

1. A battery management apparatus comprising:

    a communication unit configured to receive battery data from a plurality of battery cells; and

a control unit configured to:

fit a discharge capacity graph obtained based on the battery data to a data fitting function;
determine a regression coefficient that maximizes a coefficient of determination based on the data fitting function; and
determine, based on the regression coefficient, a maximum curvature point at which a curvature of the discharge capacity graph is maximum.

2. The battery management apparatus of claim 1, wherein the control unit is further configured to determine the plurality of battery cells as being defective based on that a curvature at the maximum curvature point is greater than a preset reference curvature.

3. The battery management apparatus of claim 1, wherein the control unit is further configured to determine the plurality of battery cells as being defective based on that a differential value, obtained by differentiating a curve of the curvature at the maximum curvature point, is 0.

4. The battery management apparatus of claim 3, wherein the control unit is further configured to transmit information about the plurality of battery cells determined as being defective to an external device through the communication unit.

5. The battery management apparatus of claim 1, wherein the control unit is further configured to fit the discharge capacity graph, obtained based on the battery data, to a data fitting function having a plurality of sine terms.

6. The battery management apparatus of claim 1, wherein the control unit is further configured to determine the maximum curvature point at which the curvature is maximum, based on a minimum search point and a maximum search point.

7. The battery management apparatus of claim 6, wherein the control unit is further configured to determine the maximum curvature point at which the curvature is maximum in a range from the minimum search point to the maximum search point.

8. The battery management apparatus of claim 7, wherein the minimum search point comprises a point at which a discharge capacity starts decreasing, and
the maximum search point comprises a maximum battery cycle that is a criterion for a battery test.

9. A battery management method comprising:

receiving battery data from a plurality of battery cells;
fitting a discharge capacity graph obtained based on the battery data to a data fitting function;
determining a regression coefficient that maximizes a coefficient of determination based on the data fitting function; and
determining, based on the regression coefficient, a maximum curvature point at which a curvature of the discharge capacity graph is maximum.

10. The battery management method of claim 9, further comprising determining the plurality of battery cells as being defective based on that a curvature at the maximum curvature point is greater than a preset reference curvature.

11. The battery management method of claim 9, further comprising determining the plurality of battery cells as being defective based on that a differential value, obtained by differentiating a curve of the curvature at the maximum curvature point, is 0.

12. The battery management method of claim 11, further comprising transmitting information about the plurality of battery cells determined as being defective to an external device through a communication unit.

13. The battery management method of claim 10, wherein the fitting of the discharge capacity graph to the data fitting function comprises fitting the discharge capacity graph, obtained based on the battery data, to a data fitting function having a plurality of sine terms.

14. The battery management method of claim 10, wherein the determining of the maximum curvature point comprises determining the maximum curvature point at which the curvature is maximum, based on a minimum search point and a maximum search point.

15. The battery management method of claim 14, wherein the determining of the maximum curvature point comprises determining the maximum curvature point at which the curvature is maximum in a range from the minimum search point to the maximum search point.

16. The battery management method of claim 14, wherein the minimum search point comprises a point at which a discharge capacity starts decreasing, and
the maximum search point comprises a maximum battery cycle that is a criterion for a battery test.

FIG.1

BATTERY MANAGEMENT APPARATUS
1

CONTROL UNIT
100

PROCESSOR
110

MEMORY
120

COMMUNICATION UNIT
200

WIRELESS
COMMUNICATION UNIT
210

WIRED
COMMUNICATION UNIT
220

CURRENT SENSOR
2

VOLTAGE SENSOR
3

EXTERNAL DEVICE
4

FIG.2

FIG.3

FIG.4

FIG.5

FIG.6

FIG.7

FIG.8

FIG.9

```
                    ┌──────────────┐
                    │    START     │
                    └──────┬───────┘
                           │
            ┌──────────────▼──────────────┐
            │  RECEIVE BATTERY DATA OF     │──1000
            │  PLURALITY OF BATTERY CELLS  │
            └──────────────┬──────────────┘
                           │
            ┌──────────────▼──────────────┐
            │  OBTAIN DISCHARGE CAPACITY   │──1010
            │  GRAPH BASED ON BATTERY DATA │
            └──────────────┬──────────────┘
                           │
            ┌──────────────▼──────────────┐
            │    FIT DISCHARGE CAPACITY    │──1020
            │    GRAPH TO SINE FUNCTION    │
            └──────────────┬──────────────┘
                           │
            ┌──────────────▼──────────────┐
            │   DETERMINE REGRESSION       │──1030
            │  COEFFICIENT THAT MAXIMIZES  │
            │ COEFFICIENT OF DETERMINATION │
            └──────────────┬──────────────┘
                           │
            ┌──────────────▼──────────────┐
            │   DETERMINE CURVATURE OF     │──1040
            │    SINE GRAPH BASED ON       │
            │    REGRESSION COEFFICIENT    │
            └──────────────┬──────────────┘
                           │
```

IS MAXIMUM CURVATURE OF SINE GRAPH DETECTED IN SEARCH RANGE AND IS DIFFERENTIAL VALUE OF CURVE OF CURVATURE AT MAXIMUM CURVATURE POINT 0? — 1050

NO → DETERMINE BATTERY STATE AS BEING NORMAL — 1070

YES → DETERMINE BATTERY STATE AS BEING ABNORMAL — 1060

END

FIG.10

**EP 4 768 969 A1**

## INTERNATIONAL SEARCH REPORT

International application No.

**PCT/KR2024/018874**

| A. | CLASSIFICATION OF SUBJECT MATTER |
|---|---|

**G01R 31/396**(2019.01)i; **G01R 31/392**(2019.01)i; **G01R 31/382**(2019.01)i; **G01R 31/36**(2006.01)i; **G06F 17/18**(2006.01)i

According to International Patent Classification (IPC) or to both national classification and IPC

| B. | FIELDS SEARCHED |
|---|---|

Minimum documentation searched (classification system followed by classification symbols)

G01R 31/396(2019.01); G01R 31/36(2006.01); H01M 10/48(2006.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (KIPO internal) & keywords: 방전용량 그래프(discharge capacity graph), 피팅 함수(fitting function), 계수 (coefficient), 곡률(curvature), 불량(defect)

| C. | DOCUMENTS CONSIDERED TO BE RELEVANT |
|---|---|

| Category* | Citation of document, with indication, where appropriate, of the relevant passages | Relevant to claim No. |
|---|---|---|
| A | KR 10-2019-0043457 A (UNIST(ULSAN NATIONAL INSTITUTE OF SCIENCE AND TECHNOLOGY)) 26 April 2019 (2019-04-26)<br>See paragraphs [0030]-[0040] and figures 1-4. | 1-16 |
| A | KR 10-2018-0062814 A (MCSCIENCE INC.) 11 June 2018 (2018-06-11)<br>See paragraphs [0040]-[0057] and figures 1-3. | 1-16 |
| A | JP 2011-208966 A (NEC CORP.) 20 October 2011 (2011-10-20)<br>See claims 1-8. | 1-16 |
| A | WO 2015-109592 A1 (BEIHANG UNIVERSITY) 30 July 2015 (2015-07-30)<br>See paragraphs [0036]-[0048] and figures 1-2. | 1-16 |
| A | CN 106093778 A (ZHEJIANG NARADA POWER SOURCE CO., LTD.) 09 November 2016 (2016-11-09)<br>See claim 1 and figures 1-6. | 1-16 |

☐ Further documents are listed in the continuation of Box C.   ☑ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| **10 March 2025** | **10 March 2025** |

| Name and mailing address of the ISA/KR | Authorized officer |
|---|---|
| **Korean Intellectual Property Office**<br>**Government Complex-Daejeon Building 4, 189 Cheongsa-ro, Seo-gu, Daejeon 35208** | |
| Facsimile No. **+82-42-481-8578** | Telephone No. |

Form PCT/ISA/210 (second sheet) (July 2022)

**INTERNATIONAL SEARCH REPORT**
Information on patent family members

International application No.

**PCT/KR2024/018874**

| Patent document cited in search report | | | Publication date (day/month/year) | Patent family member(s) | | | Publication date (day/month/year) |
|---|---|---|---|---|---|---|---|
| KR | 10-2019-0043457 | A | 26 April 2019 | KR | 10-2029230 | B1 | 08 November 2019 |
| KR | 10-2018-0062814 | A | 11 June 2018 | KR | 10-1888125 | B1 | 14 August 2018 |
| | | | | KR | 10-1952406 | B1 | 26 February 2019 |
| | | | | KR | 10-2018-0062815 | A | 11 June 2018 |
| | | | | WO | 2018-101620 | A1 | 07 June 2018 |
| JP | 2011-208966 | A | 20 October 2011 | None | | | |
| WO | 2015-109592 | A1 | 30 July 2015 | None | | | |
| CN | 106093778 | A | 09 November 2016 | CN | 106093778 | B | 04 December 2018 |

Form PCT/ISA/210 (patent family annex) (July 2022)

REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- KR 1020230182220